# EUROPÄISCHE PATENTSCHRIFT

(11) **EP 3 625 840 B1**
(45) Veröffentlichungstag und Bekanntmachung des Hinweises auf die Patenterteilung: **24.09.2025**
(21) Anmeldenummer: 18729879.9
(22) Anmeldetag: 15.05.2018
(51) Int. Cl.: H01M 4/04, H01M 4/36, H01M 4/38, H01M 4/48, H01M 4/66, H01M 10/0525, C23C 4/08, C23C 6/00, C23C 8/12, C23C 8/80, C23C 4/123

(54) **VERFAHREN ZUM HERSTELLEN EINES MIT EINER LITHIUMSCHICHT BESCHICHTETEN SUBSTRATS MITTELS EINER VERMITTLERSCHICHT SOWIE EIN BESCHICHTETES SUBSTRAT**
METHOD OF PRODUCING A COATED SUBSTRATE WITH A BUFFER LAYER AND A LITHIUM LAYER AND COATED SUBSTRATE
PROCÉDÉ POUR PRODUIRE UN SUBSTRAT REVÊTU DE LITHIUM ET D'UNE COUCHE DE LIAISON ET SUBSTRAT REVÊTU

(30) Priorität: 16.05.2017 DE 102017208218
(43) Veröffentlichungstag der Anmeldung: 25.03.2020
(73) Patentinhaber: Fraunhofer-Gesellschaft zur Förderung der angewandten Forschung e.V., 80686 München (DE); Technische Universität Dresden, 01069 Dresden (DE)
(72) Erfinder: KASKEL, Stefan, 01159 Dresden (DE); ALTHUES, Holger, 01309 Dresden (DE); SCHUMM, Benjamin, 01307 Dresden (DE); DRESEL, Nicolai, 01159 Dresden (DE); SCHÖNHERR, Kay, 01237 Dresden (DE)
(74) Vertreter: Pfenning, Meinig & Partner mbB
(86) Internationale Anmeldenummer: PCT/EP2018/062458
(87) Internationale Veröffentlichungsnummer: WO 2018/210791

(56) Entgegenhaltungen:
- EP-A1- 2 472 648
- EP-A1- 2 472 648
- JP-A- 2009 032 597
- JP-A- 2009 032 597
- US-A- 3 634 144
- US-A1- 2001 041 294
- US-A1- 2001 041 294
- US-A1- 2005 089 757
- US-A1- 2005 089 757

## Beschreibung

Die vorliegende Erfindung betrifft ein Verfahren zum Herstellen eines mit einer Lithiumschicht beschichteten Substrats aus Kupfer bzw. Nickel mittels einer Vermittlerschicht aus Kupferoxid bzw. Nickeloxid sowie ein beschichtetes Substrat.

Für eine Vielzahl von lithiumbasierten Batterietechnologien stellen metallische Lithiumanoden einen Schlüssel zu gesteigerten Energiedichten dar, beispielsweise bei Lithium-Ionen-Batterien, Lithium-Schwefel-Batterien, Festkörperbatterien oder Lithium-Luft-Batterien. Da derzeit verwendete Produktionstechnologien wie Extrudieren und Auswalzen für die benötigten Lithiumfolien mit Folienstärken kleiner 50 µm und Folienbreiten größer 100 mm aufgrund der mechanischen Eigenschaften des Lithiums an Grenzen stoßen, sind keine Prozesse zur Herstellung von Rollenware mit den genannten Abmessungen verfügbar, was einer Aufskalierung der Batterietechnologien zu größeren Zellformaten im Wege steht.

Um trotz der geringen mechanischen Stabilität von Lithium zu dünnen Materialstärken zu gelangen, wird eine dünne Lithiumfolie auf eine Kupferfolie laminiert, wie beispielsweise in der Druckschrift EP 2 472 648 A1 beschrieben, wodurch jedoch nicht die angestrebten Dicken erreichbar sind. Eine Abscheidung von metallischem Lithium auf Kupferfolie über einen Verdampfungsprozess ist beispielsweise in den Druckschriften JP 2009 032597 A,

US 2005/0089757 A1 oder WO 2005/001157 A2 beschrieben. Der Nachteil dieser Methode liegt darin, dass relativ geringe Abscheideraten resultieren und zudem neben der Kupferfolie auch Anlagenbestandteile in der Nähe des Substrats mit Lithium beschichtet werden, was zu einem erheblichen Aufwand bei Instandhaltung, Wartung und Reinigung der Anlage führt.

Mit ähnlichen Nachteilen ist auch eine elektrochemische Abscheidung von Lithium behaftet, wie beispielsweise das in der Druckschrift US 2001/041294 A1 beschrieben Verfahren. Da eine direkte Abscheidung von Lithium aus der Schmelze aufgrund eines durch die hohe Oberflächenspannung von Metallschmelzen bedingten schlechten Benetzens der Kupferfolie oder ähnlicher Substrate ebenfalls nicht ohne Weiteres möglich ist, können auch auf diesem Weg nicht die gewünschten Schichtdicken erhalten werden.

In der Druckschrift US 3634144 A ist eine Anode für Lithiumbatterien offenbart, welche ein poröses Metallsubstrat umfasst, das mit flüssigem Lithium beschichtet wird.

Der vorliegenden Erfindung liegt daher die Aufgabe zugrunde, ein Verfahren vorzuschlagen, das die genannten Nachteile vermeidet, mit dem also eine Abscheidung eines Alkalimetalls auf großen Flächen und geringen Dicken ermöglicht.

Diese Aufgabe wird erfindungsgemäß gelöst durch ein Verfahren nach Anspruch 1 und ein Substrat nach Anspruch 5. Vorteilhafte Ausgestaltungen und Weiterbildungen sind in den abhängigen Ansprüchen beschrieben.

Ein Verfahren zum Herstellen eines mit einem Alkalimetall beschichteten Substrats weist einen Schritt auf, bei dem eine Vermittlerschicht auf eine Oberfläche des Substrats aufgebracht wird. Die Vermittlerschicht ist aus einem Werk stoff, der mit dem Alkalimetall durch zumindest teilweise chemische Reduktion reagiert. Eine Oberfläche der Vermittlerschicht wird mit einem Alkalimetall beaufschlagt und anschließend das Alkalimetall in die feste Phase bzw. den festen Aggregatzustand überführt und eine Beschichtung mit dem Alkalimetall ausgebildet.

Durch eine Vermittlerschicht, die mit dem Alkalimetall durch zumindest teilweise chemische Reduktion der Vermittlerschicht chemisch reagiert bzw. eine Legierung bildet, wird eine Benetzbarkeit des Substrats hinsichtlich des Alkalimetalls verbessert, so dass auch größere Flächen beschichtet werden können und bzw. oder größere Schichtdicken erreicht werden können. Das Alkalimetall kann beim Auftragen bzw. Beaufschlagen gasförmig, flüssig oder fest sein. Die Vermittlerschicht wird typischerweise aus der Gasphase, der flüssigen Phase oder als Festkörper aufgebracht. Erfindungsgemäß ist das Alkalimetall Lithium und beim Beaufschlagen flüssig. Nach dem Aufbringen des flüssigen Lithiums ist erfindungsgemäß vorgesehen, das Lithium durch eine Temperaturreduzierung in die feste Phase bzw. den festen Aggregatzustand zu überführen. Die Oberfläche der Vermittlerschicht wird vorzugsweise bei erhöhter Temperatur, besonders vorzugsweise bei einer Schmelztemperatur des aufzubringenden Alkalimetalls mit dem Alkalimetall benetzt bzw. in Kontakt gebracht.

Nicht erfindungsgemäß kann die Vermittlerschicht aus Silizium, Zinn, Antimon, Aluminium, Magnesium, Bismut oder Legierungen der genannten chemischen Elemente ausgebildet werden bzw. die genannten Elemente oder Legierung aufweisen. Diese Elemente bzw. Legierungen bilden bevorzugt mit einem Alkalimetall wie Lithium eine Legierung.

Die Vermittlerschicht ist aus einem Werkstoff ausgebildet, der im Kontakt mit dem Alkalimetall unter Bilden einer vermittelnden Grenzfläche oder Grenzschicht reagiert, nämlich durch Reduktion eines oxidischen Werkstoffs. Der oxidische Werkstoff ist aus Kupferoxid oder Nickeloxid ausgebildet. Die Vermittlerschicht reagiert mit dem Lithium unter Bildung einer vermittelnden Grenzschicht durch zumindest partielle Reduktion des Metalloxids.

Es kann vorgesehen sein, dass die Vermittlerschicht aus einem Werkstoff ausgebildet wird, der als chemische Reaktion eine interkalation (zum Beispiel in Graphit) oder eine Insertion (zum Beispiel in LiMeO₂) des Alkalimetalls, eine Legierungsbildung oder eine Stoffumwandlung (Konversion) durch Reduktion erlaubt. Die Stoffumwandlung durch Reduktion erfolgt vorzugsweise als Cu₂O + 2 Li → Li₂O +2 Cu oder NiO + 2 Li → Li₂O + Ni.

Typischerweise ist die Vermittlerschicht als Cu₂O oder NiO ausgebildet, da diese leicht durch flüssiges Lithium reduziert werden können. Nicht erfindungsgemäß kann die Vermittlerschicht aus Lithium-Metalloxiden (wie LiCoO₂, LiNiO₂, LiFePO₄, LiMnO₂, Li₂Mn₃NiO₈, LiNiCoMnO₂, LiNiCoAlO₂, Li₄Ti₅O₁₂ oder deren Derivaten) oder Kohlenstoff in Graphitform ausgebildet werden, da diese Werkstoffe sowohl die Interkalation als auch die Insertion ermöglichen.

Die Vermittlerschicht kann durch thermisches Oxidieren, Gasphasenbeschichtungsprozesse, vorzugsweise Sputtern und bzw. oder chemische Gasphasenabscheidung (chemical vapour deposition, CVD), eine nasschemische Beschichtung und bzw. oder Tempern ausgebildet werden. Insbesondere thermisches Oxidieren einer Kupfer- oder Nickelfolie ermöglicht hierbei eine schnelle und effiziente Ausbildung der Vermittlerschicht.

Das Alkalimetall wird typischerweise durch Laserschmelzen, Schmelzen mittels einer Heizvorrichtung, Rakeln, Aufbringen mittels einer Schlitzdüse, Streichen, Sprühen von Alkalimetallschmelzen, Tauchbeschichten, Gasphasenverfahren, thermisches Spritzen, Druckwalzen und bzw. oder Laminieren aufgebracht. Mittels der beschriebenen Verfahren kann das Alkalimetall sowohl verflüssigt bzw. in einen gasförmigen Zustand überführt als auch mit definierten Abmessungen auf die Oberfläche der Vermittlerschicht aufgebracht werden. Die Vermittlerschicht kann aber auch bei einer Abscheidung des Alkalimetalls aus der Gasphase bei einer physikalischen Gasphasenabscheidung (physical vapor deposition, PVD) eingesetzt werden. Erfindungsgemäß ist das Alkalimetall Lithium und beim Beaufschlagen flüssig.

Typischerweise wird die Vermittlerschicht mit einer Dicke zwischen 0,1 nm und 1000 nm, vorzugsweise zwischen 1 nm und 500 nm, besonders vorzugsweise zwischen 10 nm und 200 nm ausgebildet, um eine ausreichende Bedeckung des Substrats für das nachfolgende Aufbringen des Alkalimetalls zu erreichen.

Das Alkalimetall ist Lithium, da vor allem Lithium für Anwendungen bei Batterien, bei denen es auf dünne Schichten ankommt, Verwendung findet.

Das Substrat ist aus Kupfer oder Nickel ausgebildet bzw. weist Kupfer oder Nickel auf und die Vermittlerschicht ist bei einem Kupfersubstrat aus Kupferoxid ausgebildet und bei einem Nickelsubstrat aus Nickeloxid.

Das Substrat ist ein solider, nicht-poröser Festkörper. Erfindungsgemäß ist das Substrat eine planare Folie mit einer Dicke von weniger als 20 µm, vorzugsweise mit einer Dicke von weniger als 10 µm.

Die thermische Oxidation kann über einen Zeitraum von nicht mehr als 2 Minuten, vorzugsweise weniger als 1,5 Minuten, besonders vorzugsweise weniger als 1 Minute durchgeführt werden, um möglichst schnell und effizient eine ausreichend dicke Oxidschicht zu generieren.

Ein mittels des beschriebenen Verfahrens hergestelltes beschichtetes Substrat weist somit eine Schichtfolge Substrat-Vermittlerschicht-Alkalimetallschicht auf. Das Substrat weist vor dem Aufbringen der Alkalimetallschicht die Vermittlerschicht auf, die aus einem Werkstoff ausgebildet ist, der mit dem Alkalimetall chemisch reagiert. Das beschichtete Substrat kann daher die bereits beschriebenen Eigenschaften aufweisen und insbesondere mit dem beschriebenen Verfahren hergestellt werden. Typischerweise wird das beschriebene Substrat als Anode in einer Batteriezelle verwendet.

Ausführungsbeispiele der Erfindung bzw. nicht erfindungsgemäße Beispiele sind in den Zeichnungen dargestellt und werden nachfolgend anhand der Figuren 1 bis 10 erläutert.

Es zeigen:
- Fig. 1: eine schematische seitliche Ansicht eines Alkalimetallauftrags mittels einer beheizten Düse;
- Fig. 2: eine Figur 1 entsprechende Ansicht des Alkalimetallauftrags mittels eines beheizten Reservoirs;
- Fig. 3: eine Figur 1 entsprechende Ansicht des Alkalimetallauftrags mittels Laserschmelzen;
- Fig. 4: eine Figur 1 entsprechende Ansicht des Alkalimetallauftrags mittels Rakeln;
- Fig. 5: eine Figur 1 entsprechende Ansicht des Alkalimetallauftrags mittels Streichen;
- Fig. 6: eine Figur 1 entsprechende Ansicht des Alkalimetallauftrags mittels einer Tauchbeschichtung;
- Fig. 7: eine Figur 1 entsprechende Ansicht des Alkalimetallauftrags mittels einer Sprühbeschichtung;
- Fig. 8: eine Figur 1 entsprechende Ansicht des Alkalimetallauftrags mittels Durchlaufdüse;
- Fig. 9: eine Figur 1 entsprechende Ansicht des Alkalimetallauftrags mittels Druckwalze und
- Fig. 10: eine Figur 1 entsprechende Ansicht des Alkalimetallauftrags mittels Gleitbeschichtung.

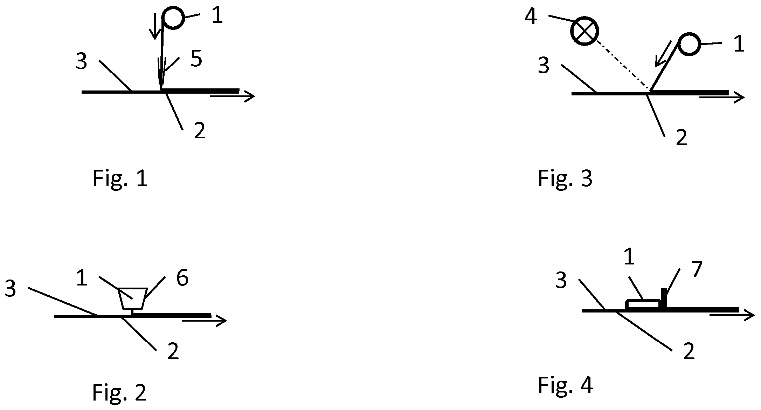

Figur 1 zeigt in einer schematischen seitlichen Ansicht ein Verfahren zum Herstellen eines mit Lithium als Alkalimetall 1 beschichteten Substrats 2. Das Substrat 2 ist im dargestellten Ausführungsbeispiel eine Kupferfolie, die durch thermische Oxidation mit einer Kupferoxidschicht als Vermittlerschicht 3 versehen wurde. Somit ist die Vermittlerschicht 3 in direktem, also unmittelbar berührendem Kontakt mit dem Substrat. Ein Aufschmelzen des Lithiums wird durch eine beheizte Düse 5 bewirkt. Die Lithiumfolie wird durch die elektrisch beheizte Düse 5 geführt und hierbei aufgeschmolzen. Fluchtend unterhalb der Düse 5 wird das Substrat 2 vorbeigetunrt, auf dem wiederum die Vermittlerschicht 3 angeordnet ist. Das geschmolzene Lithium trifft nun auf eine der Düse 5 zugewandte Oberfläche der Vermittlerschicht 3, erkaltet dort und geht wieder in einen festen Aggregatzustand über, so dass sich eine geschlossene Lithiumschicht ausbildet, die in direktem Kontakt mit der Vermittlerschicht 3 steht.

Wie in Figur 2 in einer Figur 1 entsprechenden Ansicht gezeigt, kann auch ein, vorzugsweise elektrisch, beheiztes Reservoir 6 verflüssigtes Lithium aufnehmen und durch eine dem Substrat 2 zugewandte Schlitzdüse des Reservoirs 6 das Lithium auf die Vermittlerschicht 3 auftragen. Das Reservoir 6 ist hierbei trichterförmig, um ein gezieltes Ausfließen durch die Schlitzdüse zu ermöglichen. Wiederkehrende Merkmale sind in dieser Figur und den folgenden Figuren mit identischen Bezugszeichen versehen.

In einer weiteren Ausführungsform der Erfindung, die in Figur 3 dargestellt ist, wird durch eine Laserstrahlungsquelle 4 elektromagnetische Laserstrahlung auf einen Auftreffpunkt des folienförmigen Lithiums auf das Substrat 2 bzw. die Vermittlerschicht 3 gerichtet, so dass das folienförmige Lithium an dieser Stelle verflüssigt wird und durch die Vermittlerschicht 3 aus Kupferoxid auf dem Substrat 2 angeordnet wird.

In einer weiteren Ausführungsform, die in Figur 4 wiedergegeben ist, wird das Substrat 2 beheizt und Lithium als das Alkalimetall 1 liegt als Schmelze auf dem Substrat 2 auf. Mittels eines Rakels 7 wird das Lithium mit einer definierten Dicke abgestreift und auf die Vermittlerschicht 3, die wie zuvor einer Quelle des aufzubringenden Alkalimetalls 1 zugewandt ist, aufgebracht.

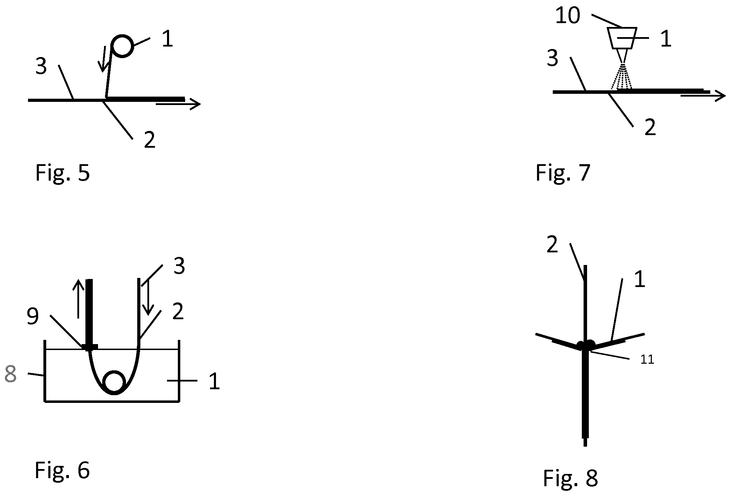

In dem in Figur 5 dargestellten Ausführungsbeispiel wird kalte Lithiumfolie über ein heißes Substrat 2 geführt. Das Substrat 2 wird hierbei durch einen elektrischen Ofen geführt und dabei erwärmt. Durch Streichen der kalten Lithiumfolie über das Substrat 2 schmilzt die Lithiumfolie am Auftreffpunkt auf der auf dem Substrat 2 aufgebrachten Vermittlerschicht 3 auf und benetzt diese Vermittlerschicht 3 flächig. Nach Erkalten liegt somit wiederum eine geschlossene Lithiumbeschichtung vor.

Figur 6 zeigt wiederum in einer scnematiscnen seitilchen Ansicht ein beheiztes Becken 8, in dem geschmolzenes Lithium enthalten ist. Das Substrat 2 mit darauf aufgebrachter Vermittlerschicht 3 wird durch das Becken 8 geführt. Beim Verlassen des Beckens 8 ist es möglich, überschüssiges Lithium an einem Abstreifer 9 abzustreifen und dadurch eine beidseitig identische Schichtdicke der Lithiumschicht auf dem Substrat 2 einzustellen.

In Figur 7 ist ein Ausführungsbeispiel gezeigt, bei die Beschichtung des mit der Vermittlerschicht 3 versehenen Substrats 2 mittels einer Sprühbeschichtung erfolgt, bei der aus einer Sprühdüse 10 auf das unterhalb der Sprühdüse 10 vorbeilaufende Substrat das Alkalimetall abgeschieden wird.

Bei dem in Figur 8 wiedergegebenen Ausführungsbeispiel erfolgt eine beidseitige Beschichtung des Substrats 2, indem von beiden Seiten Lithium als Festkörper zu dem Substrat 2 geführt wird. Da das Substrat 2 durch eine beheizte Durchlaufdüse 11 geführt wird, bevor das Lithium auf das Substrat 2 bzw. die auf beiden Seiten des Substrats 2 angeordnete Vermittlerschicht 3 auftrifft, dort aufschmilzt und das Substrat 2 derart beschichtet, dass eine geschlossene Lithiumschicht ausgebildet wird.

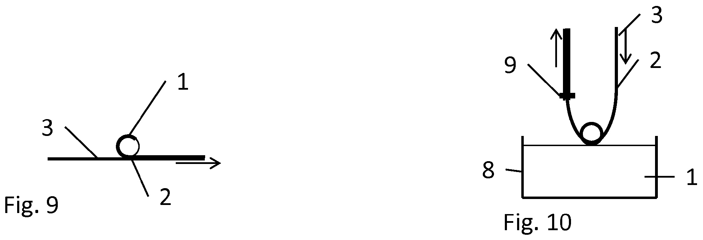

In einem weiteren, in Figur 9 dargestellten Ausführungsbeispiel erfolgt die Beschichtung des Substrats 2 durch ein Druckwalzenverfahren, indem flüssiges Lithium in oberflächliche Vertiefungen einer beheizten Auftragswalze eingebracht und mit der Walze auf das Substrat 2 transportiert, dort auf die Vermittlerschicht 3 auftrifft und abgeschieden wird.

In einem weiteren Ausführungsbeispiel, das in Figur 10 dargestellt ist, erfolgt die Beschichtung des Substrats 2 durch das gleichmäßige Übergleiten des Substrates über ein Lithiumschmelzbad, wobei das Substrat 2 gerade in Kontakt mit der Lithiumoberfläche ist. Bei diesem sogenannten Oberflächenkontaktziehen wird eine Schichtdickeneinstellung u.a. durch die Verfahrgeschwindigkeit des Substrates 2 vorgenommen. Die Beschichtungsbreite wird durch die Breite des Lithiumschmelzbades vorgenommen, sodass bei Verwendung einer Folie mit größerer Breite als das Lithiumschmelzbad ein unbeschichteter Rand erzeugt wird.

Mit dem in verschiedenen Ausführungsformen bzw. nicht erfindungsgemäßen Beispielen beschriebenen Verfahren kann somit durch Aufbringen einer dünnen, typischerweise zwischen 0,1 nm und 1000 nm dicken lithiophilen Vermittlerschicht 3 eine großflächige Abscheidung von Lithium auf unterschiedlichen Substraten 2 ermöglicht. Als Substratwerkstoffe können beispielsweise Kupferfolien, Nickelfolien, perforierte Metallfolien, Kohlefasern, insbesondere Kohlefasermatten, Vliese aus Kohlenstoffnanoröhren (CNT-Vliese), Metalldrahtgewebe oder polymere Substrate 2 wie Polyimidfolien bzw. Polyimidfasergewebe oder -gelege verwendet werden.

Die Vermittlerschicht 3 ist nicht erfindungsgemäß aus einem Werkstoff wie Silizium, Zinn, Antimon, Aluminium, Magnesium, Bismut oder einer Legierung der genannten chemischen Elemente wie CuSn, der mit Lithium eine Legierung bildet. Alternativ kann die Vermittlerschicht 3 auch aus einem Werkstoff ausgebildet sein, der im Kontakt mit flüssigem Lithium unter Bildung einer vermittelnden Grenzfläche reagiert, z. B. durch Reduktion eines oxidischen Werkstoffs zu einem Werkstoff, das mit Lithium Legierungen bildet, beispielsweise Aluminiumoxid. Dies kann z. B. auch durch Werkstoffe realisiert werden, die eine Interkalation oder eine Insertion von Lithium erlauben. Das können Werkstoffe sein, die als Aktivmaterialien in Lithium-Ionen-Batterien zum Einsatz kommen, z. B. LiCoO₂, LiNiO₂, LiFePO₄, LiMnO₂, Li₂Mn₃NiO₈, LiNiCoMnO₂, LiNiCoAlO₂, Li₄Ti₅O₁₂ oder Kohlenstoff in Graphitform. Alternativ können es allerdings auch Werkstoffe sein, die in Kontakt mit flüssigem Lithium zu Verbindungen reagieren, die Interkalation oder Insertion oder weitere chemische Reaktionen zulassen, beispielsweise Konversionswerkstoffe, bei denen keine Interkalation oder Insertion stattfindet, sondern beispielsweise ein Metalloxid direkt (reversibel) umgewandelt wird, Vanadiumoxid, Manganoxid, Eisenoxid, Kupferoxid, Schwefel oder Sulfide. Anstelle von Lithium kann in analoger Weise auch Natrium für eine Ausbildung homologer Schichten aus der Schmelze benutzt werden. Eine beispielhafte Reaktion eines Konversionswerkstoffs kann sein: MeO + 2 Li → Me + Li₂O.

Generell kann eine oxidische Vermittlerschicht 3 verwendet werden, die durch Lithium oder Natrium zumindest teilweise (aber auch vollständig) reduziert wird. Diese oxidische Vermittlerschicht kann also ein Metalloxid aufweisen, wobei als das Metalloxid Oxiae oder Oxidverbindungen folgender Elemente in Frage kommen: Magnesium, Aluminium, Silizium, Calcium, Titan, Vanadium, Chrom, Mangan, Eisen, Cobalt, Nickel, Kupfer, Zink, Zirkonium, Molybdän, Indium, Zinn, Antimon, Blei, Bismut.

Erfindungsgemäß ist die Vermittlerschicht aus Kupferoxid oder Nickeloxid.

Zum Ausbilden der Vermittlerschicht 3 können wie zum Aufbringen des Alkalimetalls 1 verschiedene Prozeduren angewandt werden. So kann beispielsweise eine 12 µm dicke Kupferfolie in einem vorgeheizten Muffelofen (oder in einem Hochtemperaturdurchlaufofen für kontinuierliche Substrate) bei 300 °C bis 500 °C oberflächlich oxidiert werden, um eine dünne Oxidschicht mit einer Dicke zwischen 0,1 nm und 1000 nm, die als die Vermittlerschicht 3 dient, zu erzeugen. In gleicher Weise kann auch durch Oxidation einer 20 µm dicken Nickelfolie eine Nickeloxidvermittlerschicht bei 600 °C ausgebildet werden. Mittels Röntgenbeugung (XRD, X-ray diffraction) kann die Bildung von Cu₂O nachgewiesen werden. In einer Ar-Umgebung kann anschließend festes Lithium in Kontakt mit der oxidierten und auf 200 °C aufgeheizten Kupferfolie gebracht werden, was zum Aufschmelzen des Lithiums führt. Mittels des Rakels 7 kann dann wie in Figur 4 gezeigt eine 20 µm bis 160 µm dicke Lithiumschicht generiert werden.

Bei dem zuvor beschriebenen Ausführungsbeispiels können Verfahrensparameter auch an die beabsichtige Anwendung angepasst werden. Bevorzugt wird für eine Minute bei 300 °C die Kupferfolie behandelt, wodurch sich eine ca. 10 nm dicke Cu₂O-Schicht bildet, die sehr gut von verflüssigtem Lithium benetzt werden kann. Bei 400-500 °C sind die Behandlungszeiten kleiner als eine Minute, jedoch bilden sich auch andere, weniger günstige Kupferoxide wie CuO.

In einer Variation dieses Ausführungsbeispiels wird die Vermittlerschicht 3 nur in bestimmten Bereichen auf dem Substrat 2 erzeugt. Auf diese Weise kann man erreichen, dass sich auch nur in diesen Bereichen die Lithiumschicht auf das Substrat 2 beaufschlagen lässt. Somit ist die Realisierung strukturierter Lithiumschichten bzw. geometrischer Formen oder die Erzeugung eines unbeschichteten Randbereichs für Stromableiterfähnchen o.ä. möglich.

In einem weiteren nicht erfindungsgemäßen Beispiel kann ein Kohlefaservlies (Freudenberg H14) für 30 s in einer ethanoscnen SnCl₂-Lösung oder SbCl₃-Lösung (0,15 M) getränkt, 5 Minuten getrocknet und anschließend an Luft im vorgeheizten Muffelofen bei 300 °C für 5 Minuten getempert werden. Daraufhin wird eine Reduktion unter Sauerstoffausschluss bei 700 °C für 60 Minuten durchgeführt. Das auf diese Weise hergestellte Substrat 2 wird anschließend in eine Lithiumschmelze getaucht.

In weiteren nicht erfindungsgemäßen Beispielen kann auch ein Kupfergewebe (Drahtdicke 0,05 mm, Maschenweite 0,2 mm) unter den gleichen Bedingungen wie die Kupferfolie behandelt und mit Lithium beschichtet werden oder es wird eine raue Kupferfolie verwendet, eine sogenannte ED-Folie, die durch Elektrodeposition dendritische Kupferstrukturen im niedrigen einstelligen µm-Bereich aufweisen, die durch thermische Oxidation wiederum in einen benetzungsfähigen Zustand überführt wird.

Während sich beispielsweise Lithiumkugeln auf einer unbehandelten Oberfläche einer Kupferfolie nicht zum Benetzen eignen, kann bei einem Erwärmen in Argon auf ungefähr 200 °C bei einer wie beschrieben behandelten Oberfläche die Lithiumkugel die Folienoberfläche benetzen. Somit können Elektroden für Sekundärbatterien wie Lithium-Ionen-Batterien, Lithium-Luft-Batterien, Lithium-Schwefel-Batterien oder Festkörperbatterien oder Elektroden für Primärbatterien wie Lithium-Thionylchlorid-Batterien, Lithium-Manganoxid-Batterien, Lithium-Schwefeloxid-Batterien, Lithium-Kohlenstoffmonofluorid-Batterien, Lithium-Iod-Batterien oder Lithium-Eisensulfid-Batterien hergestellt werden.

Lediglich in den Ausführungsbeispielen offenbarte Merkmale der verschiedenen Ausführungsformen können miteinander kombiniert werden.

## Patentansprüche

1. Verfahren zum Herstellen eines mit einer Lithiumschicht (1) beschichteten Substrats (2) aus Kupfer oder Nickel, bei dem
eine Vermittlerschicht (3) aus Kupferoxid auf eine Oberfläche des Substrats (2) aus Kupfer aufgebracht wird oder
eine Vermittlerschicht (3) aus Nickeloxid auf eine Oberfläche eines Substrats (2) aus Nickel aufgebracht wird und
eine Oberfläche der Vermittlerschicht (3) mit flüssigem Lithium beaufschlagt wird und die Vermittlerschicht (3) mit dem flüssigen Lithium durch zumindest teilweise chemische Reduktion reagiert, wobei die Vermittlerschicht (3) im Kontakt mit dem Lithium der Lithiumschicht (1) unter Bilden einer vermittelnden Grenzfläche oder Grenzschicht reagiert, und anschließend das flüssige Lithium in die feste Phase überführt sowie eine Beschichtung (1) aus dem Lithium ausgebildet wird, **dadurch gekennzeichnet, dass** das Substrat (2) als eine nicht-poröse planare Kupferfolie mit einer Dicke von weniger als 20 µm oder eine nicht-poröse planare Nickelfolie mit einer Dicke von weniger als 20 µm ausgebildet ist.

2. Verfahren nach Anspruch 1, **dadurch gekennzeichnet, dass** die Vermittlerschicht (3) durch thermisches Oxidieren, Gasphasenbeschichtungsprozesse, vorzugsweise Sputtern und/oder chemische Gasphasenabscheidung, eine nasschemische Beschichtung und/oder Tempern ausgebildet wird.

3. Verfahren nach einem der vorhergehenden Ansprüche, **dadurch gekennzeichnet, dass** das Lithium der Lithiumschicht (1) durch Laserschmelzen, Schmelzen mittels einer Heizvorrichtung, Rakeln, Aufbringen mittels einer Schlitzdüse, Sprühen, Streichen, Tauchbeschichten, thermisches Spritzen und/oder Laminieren auf die Vermittlerschicht (3) aufgebracht wird.

4. Verfahren nach einem der vorhergehenden Ansprüche, **dadurch gekennzeichnet, dass** die Vermittlerschicht (3) mit einer Dicke zwischen 0,1 nm und 1000 nm, vorzugsweise zwischen 1 nm und 500 nm, besonders vorzugsweise zwischen 10 nm und 200 nm ausgebildet wird.

5. Substrat (2) mit einer Vermittlerschicht (3) und einer Lithiumschicht (1), wobei das Substrat (2) aus Kupfer als eine nicht-poröse Kupferfolie mit einer Dicke von weniger als 20 µm und die Vermittlerschicht (3) aus Kupferoxid oder das Substrat (2) aus Nickel als eine nicht-poröse Nickelfolie mit einer Dicke von weniger als 20 µm und die Vermittlerschicht (3) aus Nickeloxid ausgebildet ist, wobei die Vermittlerschicht (3) zwischen dem Substrat (2) und der Lithiumschicht (1) durch eine zumindest teilweise chemische Reduktion der Vermittlerschicht (3) mit dem Lithium unter Bilden einer vermittelnden Grenzfläche oder Grenzschicht ausgebildet ist.

6. Batteriezelle mit einer aus dem Substrat nach Anspruch 5 gebildeten Anode.

## Claims

1. A method for producing a copper or nickel substrate (2) coated with a lithium layer (1), in which
a mediator layer (3) of copper oxide is applied to a surface of the substrate (2) of copper or
a mediator layer (3) of nickel oxide is applied to a surface of a substrate (2) of nickel, and
liquid lithium is applied to a surface of the mediator layer (3) and the mediator layer (3) reacts with the liquid lithium by at least partial chemical reduction, the mediator layer (3) reacting in contact with the lithium of the lithium layer (1) to form a mediating interface or boundary layer, and subsequently the liquid lithium is converted into the solid phase and a coating (1) is formed from the lithium, **characterized in that** the substrate (2) is a non-porous planar copper foil having a thickness of less than 20 µm or a non-porous planar nickel foil with a thickness of less than 20 µm.

2. The method according to claim 1, **characterized in that** the mediator layer (3) is formed by thermal oxidation, gas-phase coating processes, preferably sputtering and/or chemical vapour deposition, a wet-chemical coating and/or annealing.

3. The method according to one of the preceding claims, **characterized in that** the lithium of the lithium layer (1) is applied to the mediator layer (3) by laser melting, melting by means of a heating device, doctoring, application by means of a slot nozzle, spraying, brushing, dip coating, thermal spraying and/or laminating.

4. The method according to one of the preceding claims, **characterized in that** the mediator layer (3) is formed with a thickness of between 0.1 nm and 1000 nm, preferably between 1 nm and 500 nm, particularly preferably between 10 nm and 200 nm.

5. A substrate (2) having a mediator layer (3) and a lithium layer (1),
wherein the substrate (2) is formed of copper as a non-porous copper foil having a thickness of less than 20 µm and the mediator layer (3) is formed of copper oxide, or the substrate (2) is formed of nickel as a non-porous nickel foil having a thickness of less than 20 µm and the mediator layer (3) is formed of nickel oxide, the mediator layer (3) between the substrate (2) and the lithium layer (1) being formed by an at least partial chemical reduction of the mediator layer (3) with the lithium to form a mediating interface or boundary layer.

6. A battery cell comprising an anode formed from the substrate according to claim 5.

## Revendications

1. Procédé de fabrication d'un substrat (2) en cuivre ou en nickel revêtu d'une couche de lithium (1), dans lequel
une couche intermédiaire (3) d'oxyde de cuivre est appliquée sur une surface du substrat (2) en cuivre ou
une couche intermédiaire (3) d'oxyde de nickel est appliquée sur une surface d'un substrat (2) en nickel et
une surface de la couche intermédiaire (3) est exposée à du lithium liquide et la couche intermédiaire (3) réagit avec le lithium liquide grâce à une réduction chimique au moins partielle, dans lequel la couche intermédiaire (3) réagit au contact du lithium de la couche de lithium (1) en formant une interface ou une couche limite de médiation, puis le lithium liquide est converti en une phase solide et un revêtement (1) est formé à partir du lithium, **caractérisé en ce que** le substrat (2) est réalisé sous la forme d'une feuille de cuivre plane non poreuse présentant une épaisseur inférieure à 20 µm ou d'une feuille de nickel plane non poreuse présentant une épaisseur inférieure à 20 µm.

2. Procédé selon la revendication 1, **caractérisé en ce que** la couche intermédiaire (3) est formée grâce à une oxydation thermique, des procédés de revêtement en phase gazeuse, de manière préférée une pulvérisation et/ou un dépôt chimique en phase gazeuse, un revêtement chimique par voie humide et/ou un recuit.

3. Procédé selon l'une quelconque des revendications précédentes, **caractérisé en ce que** le lithium de la couche de lithium (1) est appliqué sur la couche intermédiaire (3) par fusion au laser, fusion au moyen d'un dispositif de chauffage, raclage, application au moyen d'une buse à fente, pulvérisation, peinture, revêtement par immersion, pulvérisation thermique et/ou stratification.

4. Procédé selon l'une quelconque des revendications précédentes, **caractérisé en ce que** la couche intermédiaire (3) est réalisée avec une épaisseur comprise entre 0,1 nm et 1000 nm, de manière préférée comprise entre 1 nm et 500 nm, de manière particulièrement préférée comprise entre 10 nm et 200 nm.

5. Substrat (2) comprenant une couche intermédiaire (3) et une couche de lithium (1), dans lequel le substrat (2) est réalisé en cuivre sous la forme d'une feuille de cuivre non poreuse présentant une épaisseur inférieure à 20 µm et la couche intermédiaire (3) est en oxyde de cuivre ou le substrat (2) est en nickel sous la forme d'une feuille de nickel non poreuse présentant une épaisseur inférieure à 20 µm et la couche intermédiaire (3) est en oxyde de nickel, dans lequel la couche intermédiaire (3) est formée entre le substrat (2) et la couche de lithium (1) grâce à une réduction chimique au moins partielle de la couche intermédiaire (3) avec le lithium en formant une interface ou une couche limite de médiation.

6. Cellule de batterie comprenant une anode formée à partir du substrat selon la revendication 5.
